# EUROPÄISCHE PATENTSCHRIFT

(11) **EP 0 379 026 B1**
(45) Veröffentlichungstag und Bekanntmachung des Hinweises auf die Patenterteilung: **29.03.1995**
(21) Anmeldenummer: 90100319.4
(22) Anmeldetag: 08.01.1990
(51) Int. Cl.: H04B 10/14

(54) **Laserdiodensender mit Schutz- und Alarmierungsschaltung**
Laser diode transmitter having a protection and alarm circuit
Emetteur à diode laser comportant un circuit de protection et d'alarme

(30) Priorität: 17.01.1989 DE 3901221
(43) Veröffentlichungstag der Anmeldung: 25.07.1990
(73) Patentinhaber: SIEMENS AKTIENGESELLSCHAFT, 80333 München (DE)
(72) Erfinder: Vosskämper, Jürgen, Dipl.-Ing., D-8000 München 71 (DE)

(56) Entgegenhaltungen:
- EP-A- 0 075 295
- DE-A- 3 508 034
- GB-A- 2 045 516

## Beschreibung

Die Erfindung betrifft einen Laserdiodensender entsprechend dem Oberbegriff des Anspruchs 1.

Aus der EP-B1-0075295 ist ein Laserdiodensender bekannt, bei dem in getrennten Regelkreisen der Vorstrom und der Modulationsstrom der Laserdiode geregelt wird. Zur Regelung ist mit der Laserdiode optisch eine Fotodiode als Monitordiode gekoppelt, der ein Fotostromverstärker nachgeschaltet ist. Mit dem Ausgang des Fotostromverstärkers ist zum einen der Eingang eines ersten, als Komparator geschalteten Verstärkers verbunden, dessen Ausgangssignal eine Quelle für den Laserdiodenvorstrom steuert. Zum anderen ist mit dem Ausgang des Fotostromverstärkers der Signaleingang eines Mischers verbunden,dessen Ausgang mit einem Eingang eines zweiten, als Komparator geschalteten Verstärkers verbunden ist. Der Ausgang des Verstärkers ist mit dem Regeleingang einer Quelle für den Modulationsstrom verbunden, der Ausgang dieser Quelle ist mit einem ersten Eingang eines zweiten Mischers verbunden, an dessen Ausgang die Quelle für den Laserdiodenvorstrom und die Laserdiode angeschaltet sind. Über zweite Eingänge des ersten und des zweiten Mischers wird diesem das Ausgangssignal eines von einem NF-Generator gespeisten Modulators zugeführt.

Bei einer derartigen Laserdioden-Zweikreisregelung wird durch Einfügen einer Hilfsmodulation ein Regelkriterium für den Vorstrom und den Modulationsstrom gewonnen und dadurch erreicht, daß die Laserkennlinie unbeeinflußt von etwaigen Alterungsvorgängen immer zwischen dem Laserdioden-Schwellenstrom und dem maximal zulässigen Modulationsstrom durchfahren wird. Bei der bekannten Zweikreisregelung wird bei der logischen Null, also beim Schwellenstrom der Laserdiode, ein rechteckförmiges Hilfssignal mit einem gegenüber der logischen Eins erhöhten Pegel eingeprägt, da die Kennlinie der Laserdiode im Bereich des Schwellenstroms eine geringere Steilheit als bei höherer Aussteuerung aufweist.

Der richtige Arbeitspunkt ergibt sich dabei dann, wenn die Modulationstiefe der Hüllkurve des hochfrequenten Datensignals am oberen und am unteren Rand gleich groß ist. Eine Ungleichheit der Modulationstiefe führt zu einer additiven Störkomponente, deren Betrag und Phase in der Regelschleife ausgewertet wird.

Ein Blindwerden der Monitordiode führt durch entsprechende Änderung des Ausgangssignals des Fotostromverstärkers zu einer Erhöhung des optischen Sendepegels. Der Arbeitspunkt der Laserdiode hinsichtlich des Schwellenstroms bleibt dabei zunächst erhalten, da die Auswertung der Hilfsmodulation nach Betrag und Phase nach wie vor den unteren Arbeitspunkt im Schwellenstrom konstant hält. Damit ergibt sich aber, daß ein Blindwerden der Monitordiode zu einer Erhöhung des hochfrequenten Modulationsstroms führt und sich dadurch eine Gefährdung der Laserdiode ergeben kann.

Aufgabe der Erfindung ist es, die Erhöhung des hochfrequenten Modulationsstroms zu überwachen und gleichzeitig zu begrenzen.

Die Aufgabe wird erfindungsgemäß bei einem Laserdiodensender der eingangs erwähnten Art dadurch gelöst, daß dieser durch die im Kennzeichen des Patentanspruchs 1 angeführten Merkmale weitergebildet ist. Von besonderen Vorteil bei der erfindungsgemäßen Lösung ist der vergleichsweise geringe Aufwand, mit dem sowohl eine Modulationsstrombegrenzung als auch die Erzeugung eines Alarmsignals erreicht wird. Dabei ist durch einfache Änderung eines Widerstandswertes (R17) die Amplitude des Modulationsstromes, die zum Alarm führt, einstellbar, so daß auch leicht eine Anpassung an unterschiedliche Laserdioden möglich ist.

Bevorzugte Weiterbildungen des erfindungsgemäßen Laserdiodensenders sind in den Patentansprüchen 2 und 3 beschrieben.

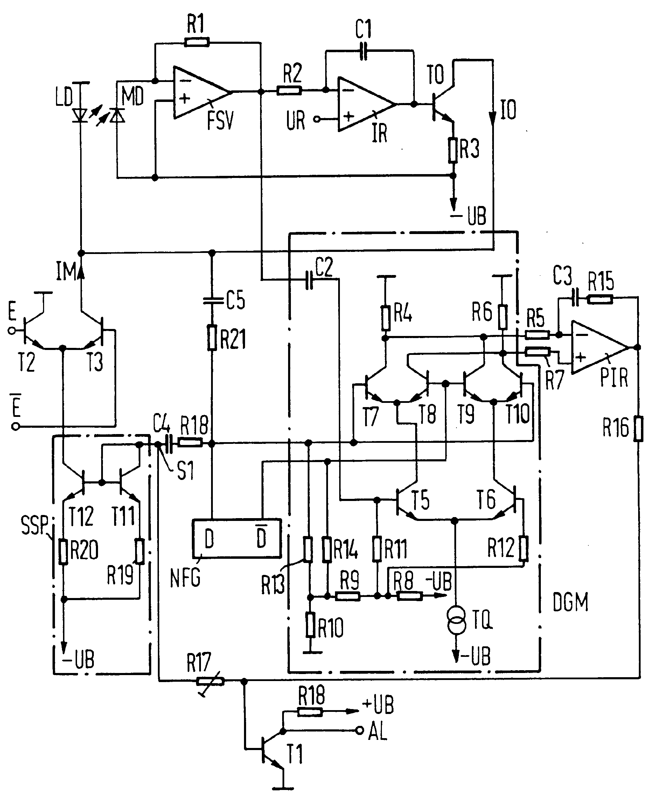

Die Erfindung soll im folgenden anhand eines in der Figur dargestellten Ausführungsbeispiels näher erläutert werden.

In der Figur ist ein Laserdiodensender mit einer Laserdiode LD und einer mit dieser optisch gekoppelten Monitordiode MD dargestellt, der für die Regelung des Laserdiodenvorstroms IO eine bekannte Schaltungsanordnung verwendet, die nur der Vollständigkeit halber dargestellt ist. Ebenso wie bei der bekannten Schaltungsanordnung sind beim Ausführungsbeispiel die beiden Anschlüsse der Monitordiode MD mit den beiden Anschlüssen eines Fotostromverstärkers FSV verbunden, der einen Operationsverstärker enthält, dessen Ausgang über einen ersten Widerstand R1 auf den Minuseingang rückgekoppelt ist, so daß ein bekannter Transimpedanzverstärker entsteht. Der Ausgang des Fotostromverstärkers FSV ist über einen zweiten Widerstand R2mit dem Minuseingang eines als I-Regler IR geschalteten Operationsverstärkers verbunden, dessen Ausgang über einen ersten Kondensator C1 auf den Minuseingang rückgekoppelt ist und dessen Pluseingang mit einer Referenzspannungsquelle UR verbunden ist. Der Ausgang des I-Reglers IR ist mit dem Basisanschluß eines Regeltransistors T0 verbunden, dessen Emitterwiderstand R3 zusammen mit dem einen Anschluß der Monitordiode MD und dem Pluseingang des Fotostromverstärkers mit einer negativen Betriebsspannungsquelle - UB verbunden ist. Der Kollektoranschluß des Regeltransistors T0 ist mit dem einen Kathodenanschluß der Laserdiode LD verbunden, so daß der Kollektorstrom dieses Transistors gleichzeitig der Vorstrom IO der Laserdiode ist, der Anodenanschluß der Laserdiode LD liegt auf Bezugspotential.

Die Modulationsstromregelung des anmeldungsgemäßen Laserdiodensenders enthält einen auch beim Stande der Technik verwendeten Niederfrequenzgenerator NFG, dessen Ausgänge über einen Doppelgegentaktmodulator DGM und einen nachgeschalteten PI-Regler PIR mit einer für die Laserdiodenansteuerung verwendeten Stromspiegelschaltung SSP verbunden sind. An die Verbindung zur Stromspiegelschaltung SSP ist der Basisanschluß eines ersten Transistors T1 angeschlossen, der die Begrenzungs- und Alarmierungsfunktion übernimmt. Mit dem Ausgang der Stromspiegelschaltung SSP sind die zusammengeführten Emitteranschlüsse eines zweiten und eines dritten Transistors T2, T3 verbunden, der Basisanschluß des zweiten Transistors T2 ist dabei mit einer Quelle E für das Modulationssignal und der Basisanschluß des dritten Transistors T3 ist mit einer Quelle E̅ für das inverse Modulationssignal verbunden. Der Kollektoranschluß des zweiten Transistors T2 liegt auf Bezugspotential, der Kollektoranschluß des dritten Transistors T3 ist zur Zuführung des Modulationsstroms IM mit dem Kathodenanschluß der Laserdiode LD verbunden, an dem auch der Laserdiodenvorstrom IO anliegt.

Der Doppelgegentaktmodulator DGM enthält eine Transistorstromquelle TQ, die einerseits mit einer negativen Betriebsspannungsquelle - UB und andererseits mit den zusammengeführten Emitteranschlüssen eines ersten Transistorpaares mit einem fünften und einem sechsten Transistor T5, T6 verbunden ist. Der Kollektoranschluß des fünften Transistors T5 ist mit den zusammengeführten Emitteranschlüssen eines aus einem siebenten und einem achten Transistor T7, T8 gebildeten weiteren Transistorpaares verbunden. In entsprechender Weise ist der Kollektoranschluß des sechsten Transistors T6 mit den zusammengeführten Emitteranschlüssen eines aus einem neunten und einem zehnten Transistor T9, T10 gebildeten weiteren Transistorpaares verbunden. Die Kollektoranschlüsse des siebenten und des neunten Transistors T7, T9 sind miteinander, über einen vierten Widerstand R4 mit Bezugspotential und über einen fünften Widerstand R5 mit dem Minuseingang des PI-Reglers PIR verbunden. In entsprechender Weise sind die Kollektoranschlüsse des achten und des zehnten Transistors T8, T10 miteinander, über einen sechsten Widerstand R6 mit Bezugspotential und außerdem über einen siebenten Widerstand R7 mit dem Pluseingang des PI-Reglers PIR verbunden.

Die Basisanschlüsse des siebenten bis zehnten Transistors T7 ... T10 werden vom Ausgangssignal des NF-Generators NFG gesteuert. Dazu ist der Basisanschluß des siebenten Transistors T7 mit dem Basisanschluß des zehnten Transistors T10 und mit dem nichtinvertierenden Ausgang D des NF-Generators NFG verbunden. Entsprechend sind die Basisanschlüsse des achten und des neunten Transistors T8, T9 miteinander und mit dem invertierenden Ausgang̅ D des NF-Generators NFG verbunden. Zur Erzeugung der Gleichspannungspotentiale für den Doppelgegentaktmodulator DGM dient eine Reihenschaltung aus einem achten, neunten und zehnten Widerstand R8, R9, R10, über den achten Widerstand R8 mit einer negativen Betriebsspannungsquelle - UB und über den zehnten Widerstand R10 mit Bezugspotential verbunden ist. Am Verbindungspunkt des achten und des neunten Widerstandes R8, R9 sind über einen elften Widerstand R11 der Basisanschluß des fünften Transistors T5 und über einen zwölften Widerstand R12 der Basisanschluß des sechsten Transistors T6 angeschlossen. Am Verbindungspunkt des neunten und zehnten Widerstandes R9, R10 sind über einen dreizehnten Widerstand die Basisanschlüsse des siebenten und des zehnten Transistors und über einen vierzehnten Widerstand R14 die Basisanschlüsse des achten und des neunten Transistors T8, T9 angeschlossen. Außerdem ist der Basisanschluß des fünften Transistors T5 über einen zweiten Kondensator C2 hochfrequenzmäßig mit dem Ausgang des Fotostromverstärkers FSV verbunden.

Zur Einstellung der Kennlinie des PI-Reglers PIR ist dessen Ausgang über die Reihenschaltung aus einem fünfzehnten Widerstand R15 und einem dritten Kondensator C3 mit dessem Minuseingang verbunden. Der Ausgang des PI-Reglers ist außerdem über einen Schutzwiderstand R16 mit dem Basisanschluß des ersten Transistors T1 und mit einem siebzehnten Widerstand R17 verbunden. Der Emitteranschluß des ersten Transistors T1 liegt auf Bezugspotential, der Kollektoranschluß dieses Transistors ist mit einem Ausgangsanschluß AL für ein Alarmsignal und über einen achtzehnten Widerstand R18 mit einem positiven Betriebsspannungsanschluß + UB verbunden. Der siebzehnte Widerstand R17 ist mit einem ersten Anschluß S1 der Stromspiegelschaltung SSP verbunden. Dieser Anschluß S1 ist außerdem über die Reihenschaltung aus einem vierten Kondensator C4 und einem achzehnten Widerstand R18 an dem nichtinvertierenden Ausgang D des NF-Generators angeschlossen. In der Stromspiegelschaltung sind die Basisanschlüsse eines elften und eines zwölften Transistors T11, T12 miteinander, mit dem Kollektoranschluß des elften Transistors T11 und mit dem Anschluß S1 verbunden. Der Emitteranschluß des elften Transistors T11 ist außerdem über einen neunzehnten Widerstand R19 und der Emitteranschluß des zwölften Transistors T12 ist über einen zwanzigsten Widerstand R20 mit der negativen Betriebsspannungsquelle - UB verbunden. Der Ausgang der Stromspiegelschaltung SSP wird durch den Kollektoranschluß des zwölften Transistors T12 gebildet, der - wie bereits beschrieben, mit den zusammengeführten Emitteranschlüssen des zweiten und des dritten Transistors verbunden ist. Der Kollektoranschluß des dritten Transistors T3 ist außerdem über eine Reihenschaltung aus einem fünften Kondensator C5 und einem einundzwanzigsten Widerstand R21 mit dem nichtinvertierenden Ausgang D des NF-Generators verbunden.

Die Begrenzung des Modulationsstroms der Laserdiode LD erfolgt zum einen über die Begrenzung der Ausgangsspannung des PI-Reglers PIR durch die Basis-Emitterstrecke des ersten Transistors T1. Durch die Begrenzung an der Emitterbasisdiode dieses Transistors wird gleichzeitig ein Alarmierungssignal am Kollektoranschluß dieses Transistors erzeugt. Der Wert des Widerstandes R17 wird dabei so eingestellt, daß die Stromspiegelschaltung SSP nur einen für die Laserdiode LD zulässigen maximalen Strom abgeben kann. Das Auftreten eines derartigen maximalen Stroms weist dann - ohne Berücksichtigung der Alterung der Laserdiode - auf eine Abnahme der Empfindlichkeit der Monitordiode hin.

Bei einem vollständigen Ausfall der Monitordiode MD erfolgt kein Empfang des niederfrequenten Hilfssignals, so daß eine Regelung nicht mehr möglich ist. Um trotzdem sicherzustellen, daß die Alarmierung auch in diesem Falle erfolgt, sind die Lastwiderstände des Doppelgegentaktmodulators, also der vierte und der sechste Widerstand R4, R6 ungleich gewählt, insbesondere ist der vierte Widerstand R4 größer als der sechste Widerstand R6. Dadurch wird eine Offsetspannung erzeugt, die bei der anschließenden Auswertung im PI-Regler einen zu geringen Wert des hochfrequenten Modulationsstroms im regulären Betrieb simuliert. Damit erfolgt auch bei vollständigem Ausfall der Monitordiode eine Begrenzung des Modulationsstroms und eine Alarmierung.

## Patentansprüche

1. Laserdiodensender mit einer Zweikreisregelung für den Vorstrom und den Modulationsstrom einer Laserdiode, an die optisch eine Monitordiode mit nachgeschaltetem Fotostromverstärker angekoppelt und im Regelkreis für den Modulationsstrom ein NF-Generator mit einem nachgeschalteten Modulator enthalten ist, an den über einen Regelverstärker die Modulationsstromquelle angeschlossen ist, wobei sich durch die Überlagerung eines vergleichsweise niederfrequenten Rechtecksignals zum Modulationssignal der Laserdiode ein Lichtausgangssignal ergibt, das durch rechteckförmige Hüllkurven amplitudenmäßig begrenzt ist, **dadurch gekennzeichnet**, daß ein an sich bekannter Doppelgegentaktmodulator (DGM) vorgesehen ist, dessen symmetrische Signaleingänge mit symmetrischen Signalausgängen des NF-Generators (NFG) verbunden sind, daß ein weiterer Signaleingang des Doppelgegentaktmodulators (DGM) mit einem Ausgang des Fotostromverstärkers (FSV) verbunden ist, daß ein erster Ausgang des Doppelgegentaktmodulators (DGM) über einen vierten Widerstand (R4) mit Bezugspotential und außerdem mit einem Minus-Eingang eines PI-Reglers (PIR) verbunden ist, daß ein zweiter Ausgang des Doppelgegentaktmodulators (DGM) über einen sechsten Widerstand (R6) mit Bezugspotential und außerdem mit dem Plus-Eingang des PI-Reglers (PTR) verbunden ist, daß der Minus-Eingang und der Ausgang des PI-Reglers (PIR) über eine Widerstands-Kondensator Serienschaltung miteinander verbunden sind und außerdem an den Ausgang des ersten Operationsverstärkers (OA1) der Basisanschluß eines ersten Transistors (T1) und über einen siebzehnten Widerstand (R17) der Eingangsanschluß einer Stromspiegelschaltung (SSP) verbunden ist, deren Ausgang mit den zusammengeführten Emitteranschlüssen eines zweiten und eines dritten Transistors (T2,T3) verbunden ist, daß die Basisanschlüsse des zweiten und dritten Transistors (T2,T3) mit einer Quelle (E,E̅) für das Modulationssignal verbunden sind, daß der Kollektoranschluß des dritten Transistors (T3) mit der Laserdiode und der Kollektoranschluß des zweiten Transistors (T2) mit Bezugspotential verbunden ist, daß der Emitteranschluß des ersten Transistors (T1) mit Bezugspotential und der Kollektoranschluß dieses Transistors mit einem Ausgangsanschluß (AL) für ein Alarmsignal und über einen achzehnten Widerstand (R18) mit einer Quelle für eine positive Betriebsspannung (+UB) verbunden ist.

2. Laserdiodensender nach Patentanspruch 1,
**dadurch gekennzeichnet**,
daß der Wert des vierten Widerstandes (R4) größer als der des sechsten Widerstandes (R6) ist.

3. Laserdiodensender nach einem der vorhergehenden Patentansprüche,
**dadurch gekennzeichnet**,
daß der Doppelgegenmodulator (DGM) eine Transistorstromquelle TQ enthält, die mit den zusammengeführten Emitteranschlüssen eines ersten Transistorpaares (T5,T6) verbunden ist,
daß die Kollektoranschlüsse jedes der Transistoren des Transistorpaares jeweils getrennt mit den zusammengeführten Emitteranschlüssen zweier weiterer Transistorpaare (T7,T8,T9,T10) verbunden sind,
daß die Basisanschlüsse jeweils eines der Transistoren der zwei weiteren Transistorpaare miteinander und mit einem Ausgangsanschluß des NF-Generators (NFG) verbunden sind,
daß die Kollektoranschlüsse derjenigen Transistoren der weiteren Transistorpaare miteinander verbunden sind, deren Basisanschlüsse nicht miteinander verbunden sind, und die miteinander verbundenen Kollektoranschlüsse über den vierten bzw. sechsten Widerstand (R4,R6) mit Bezugspotential und außerdem direkt mit dem Minus- bzw. Pluseingang des PI-Reglers (PIR) verbunden sind.

## Claims

1. Laser diode transmitter with a two-loop regulating system for the biasing current and the modulation current of a laser diode, which is optically coupled to a monitor diode with subsequent photocurrent amplifier and in which in the regulating circuit for the modulation current a LF generator with a subsequent modulator is contained which is connected to the modulation current source via a regulating amplifier, the superimposition of a comparatively low-frequency rectangular signal on the modulation signal of the laser diode resulting in a light output signal the amplitude of which is limited by rectangular envelope curves, characterized in that a double push-pull modulator (DGM), known per se, is provided, the balanced signal inputs of which are connected to balanced signal outputs of the LF generator (NFG), that a further signal input of the double push-pull modulator (DGM) is connected to an output of the photocurrent amplifier (FSV), that a first output of the double push-pull modulator (DGM) is connected to reference potential via a fourth resistor (R4) and also to a negative input of a PI controller (PIR), that a second output of the double push-pull modulator (DGM) is connected to reference potential via a sixth resistor (R6) and also to the positive input of the PI controller (PIR), that the negative input and the output of the PI controller (PIR) are connected to one another via a resistor-capacitor series circuit and, in addition, the output of the first operational amplifier (OA1) is connected to the base connection of a first transistor (T1) and, via a seventeenth resistor (R17), to the input connection of a current balancing circuit (SSP), the output of which is connected to the combined emitter connections of a second and of a third transistor (T2, T3), that the base connections of the second and third transistor (T2, T3) are connected to a source (E,E̅) for the modulation signal, that the collector connection of the third transistor (T3) is connected to the laser diode and the collector connection of the second transistor (T2) is connected to reference potential, that the emitter connection of the first transistor (T1) is connected to reference potential and the collector connection of this transistor is connected to an output connection (AL) for an alarm signal and via an eighteenth resistor (R18) to a source for a positive operating voltage (+UB).

2. Laser diode transmitter according to Claim 1, characterized in that the value of the fourth resistor (R4) is larger than that of the sixth resistor (R6).

3. Laser diode transmitter according to one of the preceding claims, characterized in that the double push-pull modulator (DGM) contains a transistor current source TQ which is connected to the combined emitter connections of a first transistor pair (T5, T6), that the collector connections of each of the transistors of the transistor pair are in each case separately connected to the combined emitter connections of two further transistor pairs (T7, T8, T9, T10), that the base connections of in each case one of the transistors of the two further transistor pairs are connected to one another and to an output connection of the LF generator (NFG), that the collector connections of the transistors of the further transistor pairs of which the base connections are not connected to one another are connected to one another, and the collector connections which are connected to one another are connected to reference potential via the fourth and sixth resistor (R4, R6) and also directly to the negative and positive input, respectively, of the PI controller (PIR).

## Revendications

1. Émetteur à diode laser comportant une régulation à deux circuits pour le courant de polarisation et le courant de modulation d'une diode laser, à laquelle est accouplée optiquement une diode de contrôle en aval de laquelle est branché un amplificateur de courant photoélectrique, tandis que dans le circuit de réglage du courant de modulation est présent un générateur basse fréquence, en aval duquel est branché un modulateur auquel la source du courant de modulation est raccordée par l'intermédiaire d'un amplificateur de régulation, un signal de sortie de lumière, dont l'amplitude est limitée par des courbes enveloppes de forme rectangulaire, étant obtenu sous l'effet de la superposition d'un signal rectangulaire à fréquence relativement basse au signal de modulation de la diode laser, caractérisé par le fait qu'il est prévu un modulateur symétrique double (DGM) connu en soi, dont les entrées symétriques de signaux sont reliées à des sorties symétriques de signaux du générateur basse fréquence (NGF), qu'une autre entrée du modulateur symétrique double (DGM) est reliée à une sortie de l'amplificateur de courant photoélectrique (FSV), qu'une première sortie du modulateur symétrique double (DGM) est reliée, par l'intermédiaire d'une quatrième résistance (R4), au potentiel de référence et, en outre, à une entrée négative d'un régulateur à action proportionnelle et intégrale (PIR), qu'une seconde sortie du modulateur symétrique double est reliée par l'intermédiaire d'une sixième résistance (R6) au potentiel de référence et, en outre, à l'entrée positive du régulateur à action proportionnelle et intégrale (PIR), que l'entrée négative et la sortie du régulateur à action proportionnelle et intégrale (PIR) sont reliées entre elles par l'intermédiaire d'un circuit série à résistance et condensateur et, qu'en outre, à la sortie du premier amplificateur opérationnel (OA1) sont raccordées la borne de base d'un premier transistor (T1) et, par l'intermédiaire d'une dix-septième résistance (R17), la borne d'entrée d'un circuit formant miroir de courant (SSP), dont la sortie est reliée aux bornes réunies des émetteurs d'un second et d'un troisième transistors (T2,T3), que les bornes de base des second et troisième transistors (T2,T3) sont reliées à une source (E, E̅) pour le signal de modulation, que la borne de collecteur du troisième transistor (T3) est reliée à la diode laser et que la borne de collecteur du second transistor (T2) est reliée au potentiel de référence, que la borne d'émetteur du premier transistor (T1) est reliée au potentiel de référence et que la borne de collecteur de ce transistor est reliée à une borne de sortie (AL) pour un signal d'alarme et, par l'intermédiaire d'une dix-huitième résistance (R18), à une source délivrant une tension de service positive (+UB).

2. Émetteur à diode laser suivant la revendication 1, caractérisé par le fait que la valeur de la quatrième résistance (R4) est supérieure à celle de la sixième résistance (R6).

3. Émetteur à diode laser suivant l'une des revendications précédentes, caractérisé par le fait
que le modulateur symétrique double (DGM) contient une source de courant à transistors TQ, qui est reliée aux bornes réunies d'émetteurs d'un premier couple de transistors (T5,T6),
que les bornes de collecteur de chacun des transistors du couple de transistors sont respectivement reliées séparément aux bornes interconnectées d'émetteurs de deux autres couples de transistors (T7,T8,T9,T10),
que les bornes de base respectivement de l'un des transistors des deux autres couples de transistors sont reliées entre elles et à une borne de sortie du générateur basse fréquence (NFG),
que les bornes de collecteur des transistors des autres couples de transistors, dont les bornes de base ne sont pas reliées entre elles, sont raccordées entre elles, et que les bornes de collecteur, qui sont reliées entre elles, sont raccordées par l'intermédiaire de la quatrième ou de la sixième résistance (R4, R6) au potentiel de référence et, en outre, directement à l'entrée négative ou à l'entrée positive du régulateur à action proportionnelle et intégrale (PIR).
